# EUROPEAN PATENT SPECIFICATION

(11) **EP 4 542 160 B1**
(45) Date of publication and mention of the grant of the patent: **04.11.2026**
(21) Application number: 24202415.6
(22) Date of filing: 25.09.2024
(51) Int. Cl.: F28F 3/08, F28F 3/04, H10W 40/00, H10W 40/73

(54) **MULTILAYER HIGH ASPECT RATIO MICROCHANNEL DEVICE**
MIKROKANALVORRICHTUNG MIT HOHEM ASPEKTVERHÄLTNIS
DISPOSITIF À MICROCANAUX À RAPPORT D'ASPECT ÉLEVÉ MULTICOUCHE

(30) Priority: 16.10.2023 US 202363590674 P; 17.04.2024 US 202418637642
(43) Date of publication of application: 23.04.2025
(73) Proprietor: ThermAvant Technologies, LLC, Columbia, MO 65202 (US)
(72) Inventor: ELLEBRACHT, Lily, Harrisburg, 65256 (US); ROLL, Derrik L., Columbia, 65202 (US); BOSWELL, Joseph, San Francisco, 94121 (US); HAYDEN, Scott, Columbia, 65202 (US); WILSON, Corey, San Francisco, 94108 (US); DIMUZIO, Philip, Myrtle Beach, 29588 (US)
(74) Representative: Ipsilon Luxembourg

(56) References cited:
- CN-A- 110 425 915
- JP-A- 2005 291 546
- KR-A- 20120 075 838
- KR-B1- 102 330 582
- US-B2- 11 391 518

## Description

### FIELD

The present teachings relate to microchannel heat transfer devices, e.g., oscillating heat pipe (OHP) devices, and more particularly to such microchannel devices having microchannels with a high aspect ratio (i.e., a high height to width ratio), and to methods of manufacturing such devices.

### BACKGROUND

The statements in this section merely provide background information related to the present disclosure and may not constitute prior art.

Some heat transfer devices, such as oscillating heat pipe (OHP) devices, have a strong performance benefit with deep-narrow channels that are closely spaced, that is having channel having with a high aspect ratio (i.e., a high height to width ratio). OHP devices generally have two competing design goals for high heat flux applications: 1) large channel size for increased flow, and 2) minimal channel width and wall width to increase the number of channels in contact with the heat source. Many manufacturing processes for making deep-narrow channels, such as CNC milling are costly, and conversely methods for making channels in a cheaper way (e.g., slitting saws) have significant limits. Therefore, a manufacturing design that enables low-cost manufacturing of complex high aspect ratio channels is desirable. Wet-etching is a low-cost manufacturing process, but cannot make deep channels with a high aspect ratio. By way of example, KR 102 330 582 B1 generally provides a heat exchanger comprising a first flow plate having a first flow path groove, a second flow plate having a second flow path groove, and an intermediate plate disposed between the first and second flow plates, wherein the intermediate plate comprises turbulence generating holes. The turbulence generating holes are configured to generate turbulence in the fluid flowing through micro-channel that is formed by first and second flow path grooves. By way of a further example, KR 2012 0075838 disclosing a multilayer microchannel heat transfer device according to the preamble of claim 1 generally provides a heat exchanger comprising a cover plate having an upper groove, a bottom plate having a bottom groove and an interplate having a flow line hole, wherein when the cover plate 25, bottom plate and interplate are stacked together the upper groove, bottom groove and flow line hole provide a large fluid path 230.

### SUMMARY

In various embodiments, the present disclosure provides innovations related to microchannel heat transfer devices, such as oscillating heat pipe (OHP) devices, heat exchangers, cold plates, loop heat pipes, heat pipes, thermosyphon, bipolar plates, microfluidics, etc., specifically to devices, and the methods of manufacturing such devices that have multiple layers of material with shallow microchannels and/or slots in each layer that are stacked to produce deep narrow fluid microchannels having a high aspect ratio.

For example, in various embodiments the present disclosure provides a microchannel heat transfer device as defined in claim 1.

This summary is provided merely for purposes of summarizing various example embodiments of the present disclosure so as to provide a basic understanding of various aspects of the teachings herein. Various embodiments, aspects, and advantages will become apparent from the following detailed description taken in conjunction with the accompanying drawings which illustrate, by way of example, the principles of the described embodiments. Accordingly, it should be understood that the description and specific examples set forth herein are intended for purposes of illustration only and are not intended to limit the scope of the present teachings.

### DRAWINGS

The drawings described herein are for illustration purposes only and are not intended to limit the scope of the present teachings in any way.
Figure 1A is an exemplary illustration of a multilayer microchannel heat transfer device comprising a first outer layer, a second outer layer and at least one interstitial layer disposed therebetween in accordance with various embodiments of the present disclosure.
Figure 1B is an exemplary exploded view of the multilayer microchannel heat transfer device shown in Figure 1A in accordance with various embodiments of the present disclosure.
Figure 2A is an exemplary cross-sectional view the multilayer microchannel heat transfer device shown in Figure 1 along line B-B in accordance with various embodiments of the present disclosure.
Figure 2B is an exemplary exploded view of the cross-sectional view shown in Figure 2A in accordance with various embodiments of the present disclosure.
Figure 3A is an exemplary illustration of the multilayer microchannel heat transfer device shown in Figure 2B wherein the device comprises layers of brazing material disposed between the first outer layer, the second outer layer and the interstitial layer(s) in accordance with various embodiments of the present disclosure.
Figure 3B is an exemplary top view of a layer of brazing material with elongated slots formed therein with support tabs spanning the elongated slots in accordance with various embodiments of the present disclosure.
Figure 4A is an exemplary top view of an interstitial layer with elongated slots formed therein with support tabs spanning the elongated slots in accordance with various embodiments of the present disclosure.
Figure 4B is an exemplary illustration of portion of the interstitial layer shown in Figure 4A illustrating the elongated slots and support tabs in accordance with various embodiments of the present disclosure.
Figure 4C is an exemplary illustration of portion of the interstitial layer shown in Figure 4A illustrating the elongated slots and support tabs in accordance with various other embodiments of the present disclosure.
Figure 5 is an exemplary exploded view of the multilayer microchannel heat transfer device shown in Figure 3A wherein the brazing layers are separate and independent from the first outer layer, the second outer layer and interstitial layer(s) in accordance with various embodiments of the present disclosure.
Figure 6A is an exemplary cross-sectional view of a slice of the multilayer microchannel heat transfer device shown in Figure 1 between lines A-A and B-B, wherein the device comprises the brazing layers and wherein the interstitial layer elongated slots are formed as deep wide slots in accordance with various embodiments of the present disclosure.
Figure 6B is an exemplary cross-sectional view of a slice of the multilayer microchannel heat transfer device shown in Figure 1 between lines A-A and B-B, wherein the device comprises the brazing layers and wherein the interstitial layer elongated slots are formed as interconnecting shallow wide slots in accordance with various other embodiments of the present disclosure.
Figure 6C is an exemplary cross-sectional view of a slice of the multilayer microchannel heat transfer device shown in Figure 1 between lines A-A and B-B, wherein the device comprises the brazing layers disposed on one or more face on one or more of the first outer layer, the second outer layer and the interstitial layer(s) as cladding in accordance with various other embodiments of the present disclosure.
Figure 7 is an exemplary cross-sectional view of the multilayer microchannel heat transfer device shown in Figure 1 along line B-B, wherein the device comprises a plurality of interstitial layers in accordance with various other embodiments of the present disclosure.
Figure 8 is an exemplary cross-sectional view of the multilayer microchannel heat transfer device shown in Figure 1 along line B-B, wherein the device comprises a plurality of interstitial layers disposed between an first and a second outer cover layer in accordance with various other embodiments of the present disclosure.

Corresponding reference numerals indicate corresponding parts throughout the several views of drawings.

### DETAILED DESCRIPTION

The following description is merely exemplary in nature and is in no way intended to limit the present teachings, application, or uses. Throughout this specification, like reference numerals will be used to refer to like elements. Additionally, the embodiments disclosed below are not intended to be exhaustive or to limit the invention to the precise forms disclosed in the following detailed description. Rather, the embodiments are chosen and described so that others skilled in the art can utilize their teachings. As well, it should be understood that the drawings are intended to illustrate and plainly disclose presently envisioned embodiments to one of skill in the art, but are not intended to be manufacturing level drawings or renditions of final products and may include simplified conceptual views to facilitate understanding or explanation. As well, the relative size and arrangement of the components may differ from that shown and still operate within the scope of the invention.

As used herein, the word "exemplary" or "illustrative" means "serving as an example, instance, or illustration." Any implementation described herein as "exemplary" or "illustrative" is not necessarily to be construed as preferred or advantageous over other implementations. All of the implementations described below are exemplary implementations provided to enable persons skilled in the art to practice the disclosure and are not intended to limit the scope of the appended claims.

Unless otherwise defined, all technical and scientific terms used herein have the same meaning as commonly understood by one of ordinary skill in the art to which this disclosure belongs. The terminology used herein is for the purpose of describing particular example embodiments only and is not intended to be limiting. As used herein, the singular forms "a", "an", and "the" may be intended to include the plural forms as well, unless the context clearly indicates otherwise. The terms "comprises", "comprising", "including", and "having" are inclusive and therefore specify the presence of stated features, integers, steps, operations, elements, and/or components, but do not preclude the presence or addition of one or more other features, integers, steps, operations, elements, components, and/or groups thereof. The method steps, processes, and operations described herein are not to be construed as necessarily requiring their performance in the particular order discussed or illustrated, unless specifically identified as an order of performance. It is also to be understood that additional or alternative steps can be employed.

When an element, object, device, apparatus, component, region or section, etc., is referred to as being "on", "engaged to or with", "connected to or with", or "coupled to or with" another element, object, device, apparatus, component, region or section, etc., it can be directly on, engaged, connected or coupled to or with the other element, object, device, apparatus, component, region or section, etc., or intervening elements, objects, devices, apparatuses, components, regions or sections, etc., can be present. In contrast, when an element, object, device, apparatus, component, region or section, etc., is referred to as being "directly on", "directly engaged to", "directly connected to", or "directly coupled to" another element, object, device, apparatus, component, region or section, etc., there may be no intervening elements, objects, devices, apparatuses, components, regions or sections, etc., present. Other words used to describe the relationship between elements, objects, devices, apparatuses, components, regions or sections, etc., should be interpreted in a like fashion (e.g., "between" versus "directly between", "adjacent" versus "directly adjacent", etc.).

As used herein the phrase "operably connected to" will be understood to mean two are more elements, objects, devices, apparatuses, components, etc., that are directly or indirectly connected to each other in an operational and/or cooperative manner such that operation or function of at least one of the elements, objects, devices, apparatuses, components, etc., imparts or causes operation or function of at least one other of the elements, objects, devices, apparatuses, components, etc. Such imparting or causing of operation or function can be unilateral or bilateral.

As used herein, the term "and/or" includes any and all combinations of one or more of the associated listed items. For example, A and/or B includes A alone, or B alone, or both A and B.

Although the terms first, second, third, etc. can be used herein to describe various elements, objects, devices, apparatuses, components, regions or sections, etc., these elements, objects, devices, apparatuses, components, regions or sections, etc., should not be limited by these terms. These terms may be used only to distinguish one element, object, device, apparatus, component, region or section, etc., from another element, object, device, apparatus, component, region or section, etc., and do not necessarily imply a sequence or order unless clearly indicated by the context.

Moreover, it will be understood that various directions such as "upper", "lower", "bottom", "top", "left", "right", "first", "second" and so forth are made only with respect to explanation in conjunction with the drawings, and that components may be oriented differently, for instance, during transportation and manufacturing as well as operation. Because many varying and different embodiments may be made within the scope of the concept(s) taught herein, and because many modifications may be made in the embodiments described herein, it is to be understood that the details herein are to be interpreted as illustrative and non-limiting.

In various embodiments, the present disclosure provides innovations related to microchannel heat transfer devices, such as heat exchangers, cold plates, loop heat pipes, heat pipes, thermosyphon, bipolar plates, microfluidics, etc., wherein the devices have multiple layers of material (e.g., two outer layers and at least one middle or interstitial layer) having shallow channels and/or slots formed therein that are stacked and bonded together to produce a multilayer device having internal deep narrow multilayer composite fluid microchannels, e.g., microchannels having a high aspect ratio. In various other embodiments, the present disclosure provides innovations related to the manufacturing of such devices. Although the present disclosure is applicable to all microchannel heat transfer devices, such as heat exchangers, cold plates, loop heat pipes, heat pipes, thermosyphon, bipolar plates, microfluidics, etc., for clarity and simplicity the present disclosure will exemplarily describe and illustrate the devices and methods of manufacturing such devices with regard to oscillating heat pipe (OHP) devices, however the scope the present disclosure should not be interpreted to be limited to such OHP devices and methods of manufacturing.

Generally, an OHP device is a passive heat transfer device that transports heat using a saturated two-phase working fluid hermetically sealed within the capillary-sized OHP channels (e.g., microchannels) formed within and enclosed within a body of the device. The hydraulic diameter of the OHP microchannels is small enough and the surface tension of the working fluid is great enough such that the OHP microchannels have a capillary effect on the working fluid causing the working fluid to disperse itself throughout the interior area of the OHP microchannels in discrete liquid plugs and vapor bubbles. Generally, the OHP microchannels have a meandering path traveling between areas of the body in thermal contact with one or more heat source (e.g., an electronic device such as an integrated circuit semiconductor device, or other heat generating device that is provided, disposed, integrally formed with, or fabricated on the body) and areas of the body in thermal contact with one or more heat sink or cooling zone. When heat from a heat source(s) is/are absorbed by the working fluid, the resulting working fluid evaporation and condensation process, as described below, creates pressure imbalances within the OHP microchannels that, coupled with the random distribution of liquid plugs and vapor bubbles, generates motion of the two-phase mixture within the OHP microchannels.

More specifically, the OHP microchannels are integrally formed and enclosed internally within the body and pass near and/or adjacent and/or in close proximity (e.g., within approximately one to thousands of microns) to heat absorption regions of the body (e.g., areas of the body having the heat source(s) disposed thereon or integrally formed therewith) and also pass near and/or adjacent and/or in close proximity (e.g., within approximately one to thousands of microns) to heat rejection regions of the body (e.g., areas of the body absent the heat source(s) and/or in thermally conductive contact with a heat sink or cooling device/system). As heat is absorbed from heat absorption regions (also known as evaporator regions) by the working fluid within the OHP microchannels, evaporation of the working fluid occurs and the capillary dimensions of the OHP microchannels (e.g., from hundreds of nanometers to tens of thousands of microns, and in some instances up to approximately 1.0 inch) forces the working fluid into a train of liquid plugs and vapor bubbles. The train of liquid plugs and vapor bubbles creates a pressure imbalance within the OHP microchannels. This pressure imbalance forces the working fluid to move within the OHP microchannels, thereby transferring the heat (e.g., both latent and sensible heat) from the heat absorption regions (also known as evaporator regions) to the heat rejection region(s) of the body (also known as condenser region(s)) where the heat of the vapor phase working fluid is rejected into the ambient air and/or heat sink or cooling device/system.. When the heat of the vapor phase working fluid is rejected the vapor phase working fluid converts back to liquid phase, which then moves back to the heat absorption region(s) of the body to repeat the evaporationcondensation cycle to continuously remove heat from, and cool, the heat sources and the OHP device overall.

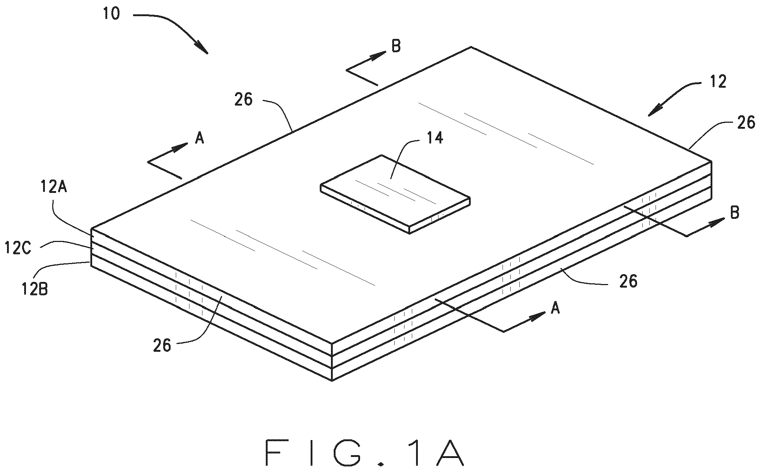

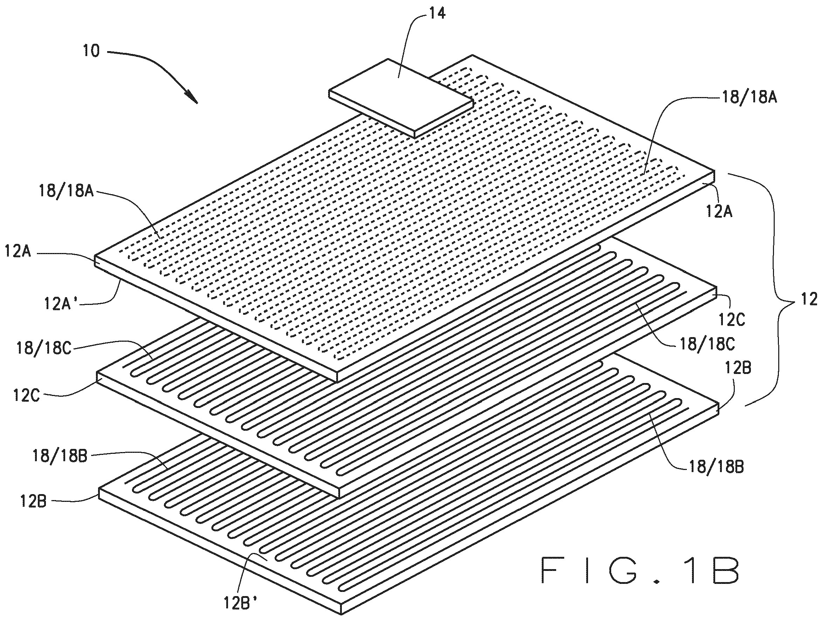

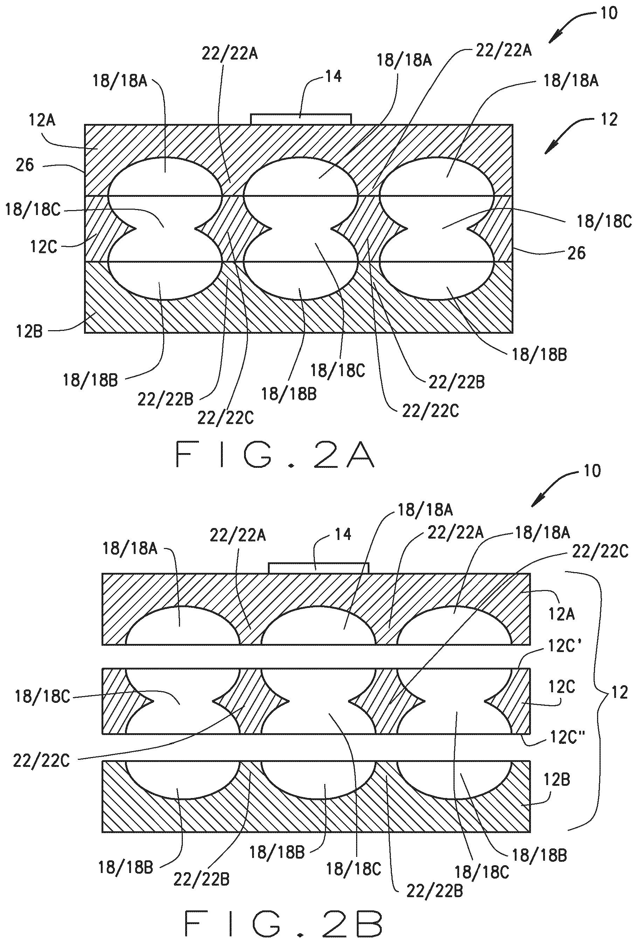

Referring to Figures 1A, 1B, 2A and 2B, generally, the device of the present disclosure, and method of manufacturing the device, provide a multilayer microchannel heat transfer device 10 comprising one or more shallow narrow multilayer composite microchannel 18 having a high width to depth aspect ratio. The device 10 can be manufactured with high throughput and low cost, wherein the multilayer composite microchannel(s) 18 are generally densely packed, have structural integrity, and have local and global hermeticity between adjacent channels and from the surrounding environment.

For example, in various embodiments, the present disclosure provides a multilayer microchannel heat transfer device 10. The device 10 comprises a multilayer microchannel heat transfer body 12 having at least one multilayer composite microchannel 18 (e.g., at least one composite OHP microchannel) formed internally and enclosed within the body 12. The multilayer microchannel heat transfer body 12 is structured and operable to remove heat, via the multilayer composite microchannel(s) 18, from one or more heat source 14 (e.g., an electronic device such as a semiconductor device or other heat generating device) that is provided, disposed on, integrally formed with, or fabricated with the body 12 and transfer or spread the removed heat across a surface area of body 12 where the removed heat is rejected to the ambient environment or other suitable heat sink device or system that is in thermal contact with the body 12. In various embodiments, the multilayer composite microchannel(s) 18 is/are formed to be meandering microchannel(s) having a generally serpentine shape that internally traverse(s) portions or all of the body 12.

The multilayer microchannel heat transfer body 12 comprises an upper or first outer layer, plate, panel, stratum or substrate 12A, a lower or second outer layer, plate, panel, stratum or substrate 12B, and one or more middle or interstitial layer, plate, panel, stratum or substrate 12C disposed between and bonded to the first and second outer layers 12A and 12B. The first outer layer 12A includes one or more micro-sized shallow first elongated recess or channel 18A formed or disposed (e.g., milled or etched, e.g., wet etched) into a first face 12A' thereof. The first elongated recess(es) 18A is/are formed or disposed in the first face 12A' to have a desired pattern, path, array or shape (e.g., a substantially serpentine pattern). The second outer layer 12B includes one or more shallow second micro-sized elongated recess or channel 18B formed or disposed (e.g., milled or etched, e.g., wet etched) into a first face 12B' thereof. The second elongated recess(es) 18B is/are formed or disposed in the first face 12B' to have the same pattern, path, array or shape (e.g., a substantially serpentine pattern) as the first elongated recess(es) 18A. The interstitial layer(s) 12C include one or more micro-sized elongated slot 18C formed or cut (e.g., milled or etched, e.g., wet etched) into and extending through each respective interstitial layer 12C. The elongated slot(s) 18C is/are formed or cut through each respective interstitial layer 12 to have the same pattern, path, array or shape (e.g., a substantially serpentine pattern) as the first and second elongated recess(es) 18A and 18B. Micro-sized will understood herein to mean that the first elongated recess(s) 18A, the second elongated recess(es) 18B and the elongated slot(s) 18C have dimension measured in 0.001 of an inch, for example, in various instances, the first and second elongated recess(s) 18A and 18B can have a width of 0.005 to 0.200 inches and a depth of 0.005 to 0.400 inches, and the elongated slot(s) 18C have a width of 0.005 to 0.200 inches and a depth of 0.005 to 0.400 inches.

As described above, the first outer layer 12A, the second outer layer 12B and the one or more interstitial layer 12C are stacked and boded together having the interstitial layer(es) 12C disposed between the first outer layer 12A, the second outer layer 12B to form the body 12 of the multilayer microchannel heat transfer device 10. More specifically, the first outer layer 12A, the second outer layer 12B, and the interstitial layer(s) are stacked and bonded together having the one or more interstitial layer disposed between the first and second outer layer such that the first elongated recess(es) 18A in the first outer layer 12A, the second elongated recess(es) 18B in the second outer layer 12B and the elongated slot(s) 18C in the interstitial layer(s) 12C are aligned, stacked and combined to form at least one composite deep narrow multilayer composite microchannel 18 internally disposed and enclosed within the resulting body 12 of multilayer microchannel heat transfer device 10.

Referring now to Figures 1A, 1B, 2A, 2C, 3A and 3B, the first outer layer 12A, the second outer layer 12B and the interstitial layer(s) 12C can be stacked and boded together using any suitable means and method (e.g., brazing, diffusion bonding, ultrasonic welding, etc.) suitable to provide a hermetic seal between the first, second and interstitial layers 12A, 12B, 12C at interior channel walls 22 between adjacent portions or sections of the multilayer composite microchannel(s) 18 (referred to here as internal hermetic sealing), and between portions or sections of the multilayer composite microchannel(s) 18 and the exterior sidewalls 26 of the body 12 (i.e., between portions or sections of the multilayer composite microchannel(s) 18 and the exterior ambient environment surrounding the device 10) (referred to herein as exterior hermetic sealing). As illustrated in the various figures the interior channel walls 22 are a composite of interior channel wall sections 22A formed in and provided by the first outer layer 12A, interior channel wall sections 22B formed in and provided by the second outer layer 12B, and the interior channel wall sections 22C formed in and provided by the interstitial layer(s) 12C. Additionally, in embodiments wherein the first, second and interstitial layer(s) 12A, 12B and 12C are boded together using brazing layers 30 (described below) the interior channel walls 22 are a composite of interior channel wall sections 22A formed in and provided by the first outer layer 12A, interior channel wall sections 22B formed in and provided by the second outer layer 12B, the interior channel wall sections 22C formed in and provided by the interstitial layer(s) 12C, and the interior channel wall sections 22D formed in and provided by the brazing layers 30 (described below).

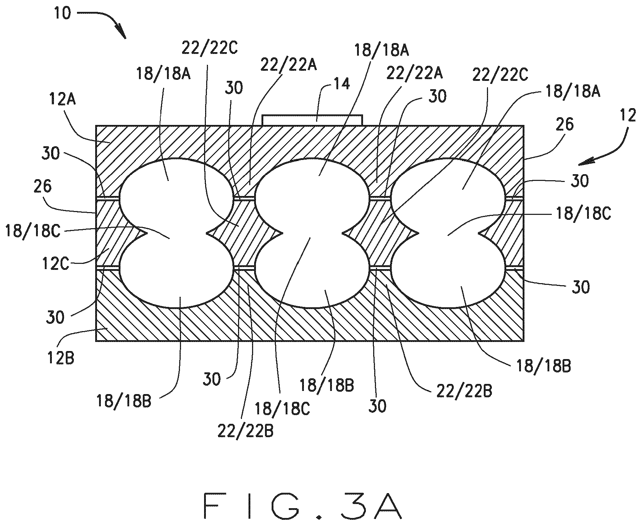

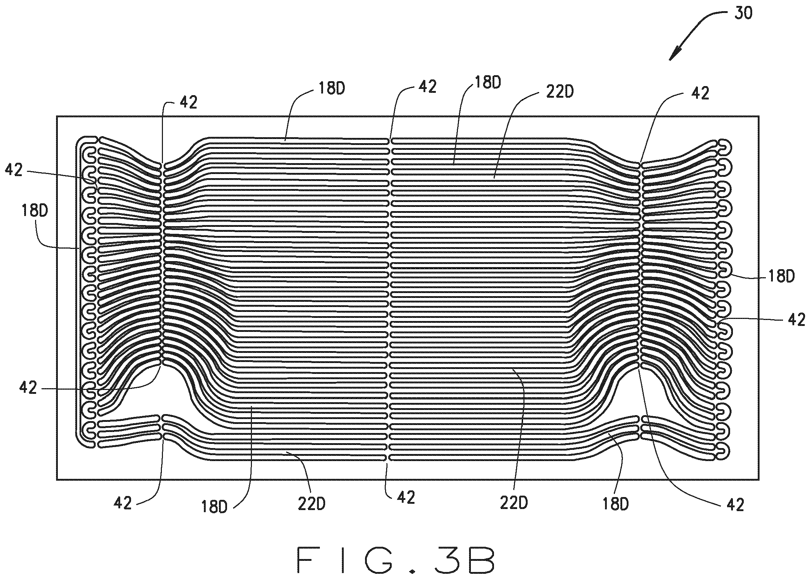

For example, as exemplarily illustrated in Figures 3A and 3B, in various embodiments one or more layer 30 of brazing material (e.g., a material with a lower melting temperature than the material from which the first, second and interstitial layers 12A, 12B, 12C are fabricated) can be disposed between the first outer layer 12A and the adjacent interstitial layer 12C, between the second outer layer 12B and the adjacent interstitial layer 12C, and between adjacent interstitial layers 12 when the body 12 comprises more than one interstitial layer 12C. In such embodiments, a layer 30 of a brazing material (e.g., a sheet of brazing material) can be disposed between the adjacent first, second and interstitial layers 12A, 12B, 12C whereafter a compressive force is applied to the aligned and stacked adjacent first, second and interstitial layers 12A, 12B, 12C and the aligned and stacked adjacent first, second and interstitial layers 12A, 12B, 12C are heated such that the brazing layers 30 melt and hermetically seal the first, second and interstitial layers 12A, 12B, 12C together (i.e., internally and exteriorly hermetically seal the first, second and interstitial layers 12A, 12B, 12C together). In various embodiments, one or more of the brazing layers 30 is/are fabricated or prepared (e.g., etched, milled, cut, etc.) to have one or more elongated slot 18D formed or cut (e.g., milled, cut or etched, e.g., wet etched) into and extending through each respective brazing layer 30 wherein the elongated slot(s) 18D have the same pattern, path, array or shape (e.g., a substantially serpentine pattern) as the first and second elongated recess(es) 18A and 18B in the first and second layers 12A and 12B and the elongated slots 18C in the interstitial layer(s) 12C. The brazing layer elongated slot(s) 18D form and define brazing layer interior channel walls sections 22D.

As described above, the first and second elongated recess(es) 18A and 18B are formed or disposed in the first faces 12A' and 12B' of the first outer and second outer layers 12A and 12B utilizing any suitable means for forming, creating or disposing the elongated recess(es) 18A in the first outer layer 12A such as milling or etching. For example, in various embodiments a wet etching process is used to form wide shallow elongated recess(es) 18A and 18B in the first face 12A' and 12B' of the first and second outer layers 12A and 12B. Similarly, as described above, the elongated slot(s) 18C is/are formed, created or disposed through the interstitial layer(s) 12C utilizing any suitable means such as milling or etching. For example, in various embodiments a wet etching process is used to form the slot(s) 18C to have substantially the same width as the shallow elongated recess(es) 18A and 18B in the first and second outer layers 12A and 12B. As exemplarily illustrated in Figures 2A, 2B and 2C, in various embodiments one or more wide shallow elongated recess having substantially the same width as the shallow elongated recess(es) 18A and 18B can be etched in opposing faces 12C' and 12C" of the respective interstitial layer 12C such that the opposing elongated recesses intersect, interconnect and fluidly connect to form the elongated slot(s) 18C. Alternatively, the elongated slot(s) can be etched or milled through the entire thickness of the respective interstitial layer 12C to have substantially the same width as the shallow elongated recess(es) 18A and 18B.

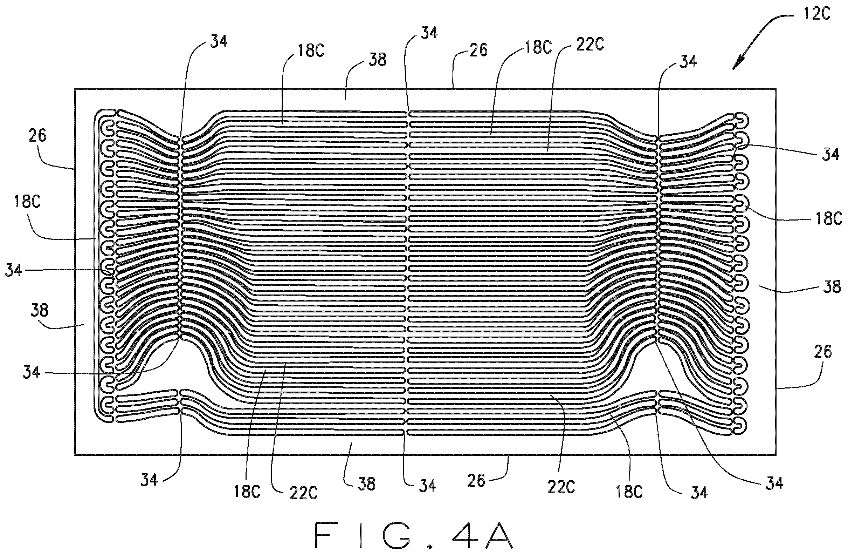

Referring now to Figures 1A, 1B, 2A, 2C, 3A, 3B, 4A, 4B and 4C, as described above the elongated slots 18C formed in the interstitial layer(s) 12C extend through the entire thickness of the respective interstitial layer 12C. As one skilled in the art would readily understand, when the elongated slots 18C are formed, created or disposed through the respective interstitial layer 12C the material that remains and forms, provides or defines the respective interstitial layer interior channel wall sections 22C will have little or no material connecting the interior channel wall sections 22C to the remaining structure (e.g., the perimeter structure) of the respective interstitial layer 12C. As such, the interior channel wall sections 22C will either fall out or away from the remaining structure or be unstable and difficult or impossible to accurately align with the interior channels wall sections 22A and 22B of the first and second outer layers 12A and 12B when the respective layers are stacked and bonded together. Therefore, in various embodiments, the elongated slots 18C are formed, created or disposed through the interstitial layer(s) 12C to have a plurality of support tabs 34 that extend across each elongated slot 18C to connect each interior channel wall section 22C to adjacent interior channel wall sections 22C and/or to outer perimeter sections 38 that are defined and disposed between the portions of the elongated slots 18C that are nearest the body sidewalls 26 and the body sidewalls 26. It should be noted that the location and number of support tabs 34 in Figure 4A are only exemplarily and the location and number of support tabs 34 in each elongated slot 18C can vary in number and location and remain within the scope of the present disclosure. Additionally, the number and location support tabs 34 in each elongated slot 18C can vary between adjacent interstitial layers 12C and remain within the scope of the present disclosure.

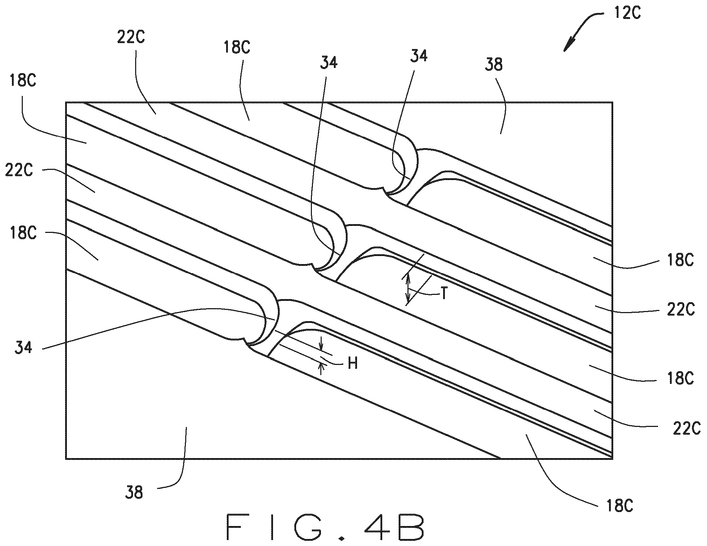

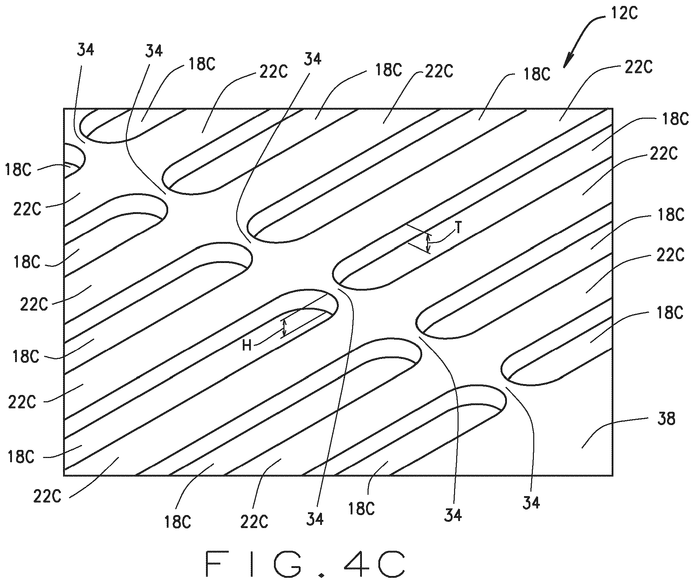

The support tabs 34 provide interconnection between the plurality of interior channel wall sections 22C and between the interior channel wall sections 22C and the perimeter wall sections 38. Moreover, the support tabs 34 provide alignment stability of the interior channel wall sections 22C such that the interior channel wall sections 22C of the interstitial layer(s) 12C, and the elongated slots 18C can respectively be accurately aligned with and mated or matched with the interior channel walls sections 22A and 22B and the first and second elongated recesses 18A and 18B of the first and second outer layers 12A and 12B when the respective layers are stacked and bonded together. As exemplarily illustrated in Figure 4B, in various embodiments the support tabs 34 are formed within the elongated slots 18C such that a height H of one or more support tab 34 is less than a thickness T of the respective interstitial layer 12C. Alternatively, as exemplarily illustrated in Figure 4C, in various embodiments, the support tabs 34 are formed within the elongated slots 18C such that the height H of one or more support tab 34 is substantially equal to the thickness T of the respective interstitial layer 12C.

As described above, in various embodiments, layers 30 of brazing material having the elongated slot(s) 18D formed therein can be disposed between the first out layer 12A and the adjacent interstitial layer 12C, between the second outer layer 12B and the adjacent interstitial layer 12C, and between adjacent interstitial layers 12C (if more than one interstitial layer 12C), whereafter the brazing layers 30 and the first outer, second outer and interstitial layers 12A, 12B, 12C are stacked and aligned such that the interior channel wall sections 22A, 22B and 22C, and hence the first and second elongated recesses 18A and 18B and the elongated slots 18C, are aligned to form, define and provide the composite microchannel(s) 18. Thereafter, a compressive force is applied to the aligned and stacked first, second and interstitial layers 12A, 12B, 12C and the aligned and stacked first, second and interstitial layers 12A, 12B, 12C are heated to a temperature whereat the brazing layers 30 melt and hermetically seal the first, second and interstitial layers 12A, 12B, 12C together (i.e., internally and exteriorly hermetically seal the first, second and interstitial layers 12A, 12B, 12C together).

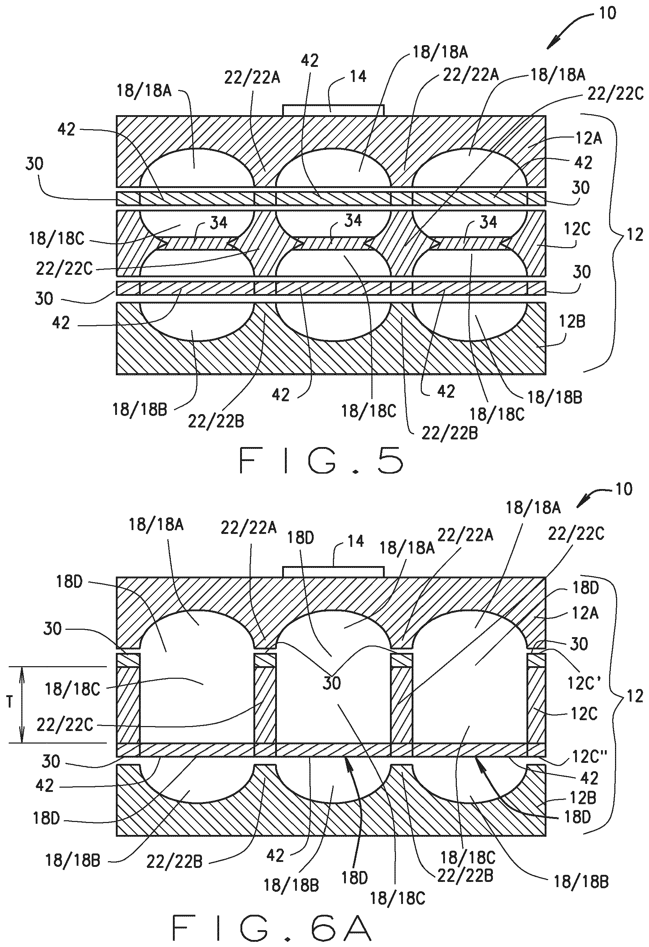

In embodiments where the brazing layers 30 are independent and separate from the interstitial layer(s) 30, the elongated slot(s) 18C of interstitial layer(s) 30 will include the support tab(s) 34 as described above. Additionally, the elongated slot(s) of the brazing layers 30 will also be formed, created or disposed therethrough to have a plurality of support tabs 42, as exemplarily illustrated in Figures 3B and 5. The brazing layer support tabs 42 extend across each elongated slot 18D to connect each interior channel wall section 22D to adjacent interior channel wall sections 22D and/or to outer perimeter sections 44 that are defined and disposed between the portions of the elongated slots 18D that are nearest the body sidewalls 26 and the body sidewalls 26. As with the interstitial layer(s) 12C, the support tabs 42 of the brazing layers 30 provide alignment stability of the brazing layer interior channel wall sections 22D such that the interior channel wall sections 22D of the brazing layers 30 and the elongated slots 18D can respectively be accurately aligned with and mated or matched with the interior channel walls sections 22A, 22B and 22C and the first and second elongated recesses 18A and 18B of the first and second outer layers 12A and 12B and the elongated slots 18C of the interstitial layers 30 when the respective layers are stacked and bonded together. It should be noted that the location and number of support tabs 42 in Figure 3B are only exemplarily and the location and number of support tabs 34 in each elongated slot 18D can vary in number and location and remain within the scope of the present disclosure. Additionally, the number and location support tabs 42 in each elongated slot 18D can vary between adjacent braze layers 30 and remain within the scope of the present disclosure.

Referring now to Figures 1A, 1B, 3A, 6A, 6B and 6C, in various embodiments, each interstitial layer 30 can be fabricated to include (i.e., be clad with) a brazing layer 30 disposed on one or both faces 12C' and 12C", wherein the brazing layer(s) 30 is/are fabricated of a material (e.g., Aluminum 4004, Aluminum 4043, silver, nickel, etc.) that has a lower melting temperature than the material (e.g., alloy aluminum) from which the core interstitial layer 12C is fabricated. As used herein the term/phrase "cladding" or "clad with" (e.g., the faces 12C' and 12C" are clad with a brazing layer 30), will be understood to mean two or more layers of dissimilar material or alloy fused together into a plate, sheet, or foil form.

As described above, the elongated slot(s) 18C of each interstitial layer 12C can be formed or cut using any suitable device, means or method such as milling or wet etching. As would be readily understood by one skilled in the art, in the embodiments wherein both faces 12C' and 12C" of one or more interstitial layer 12C are clad to have a brazing layer 30 disposed thereon, one or both of the brazing layers 30 will need to be cut, milled or etched to provide the brazing layer elongated slots 18D whereafter the interstitial layer elongated slot(s) 18C can be cut, milled or etched to provide the interstitial layer elongated slots 18C. However, to prevent the interior channel wall sections 22C of the interstitial layer(s) 12C from falling out or away from the remaining structure, either the interstitial layer support tabs 34 will need to be formed or provided within the interstitial layer elongated slots 18C as described above, or the brazing layer support tabs 42 will need to be formed or provided within the elongated slots 18D of the braze layer 30 (if the interstitial layer 12C is clad with only one brazing layer 30) or one of the two braze layers 30 (if the interstitial layer 12C is clad with only one brazing layer 30), as described above.

For example, as exemplarily illustrated in Figure 6A, in various embodiments wherein both faces 12C' and 12C" of an interstitial layer 12C are clad with a brazing layer 30, the interstitial layer elongated slots 18C can be formed or cut by first removing (e.g., milling or etching) the brazing material of one of the brazing layers 30 to form the brazing layer elongated slots 18D. Thereafter wide deep elongated slot(s) having substantially the same pattern, path, array or shape and width as the shallow elongated recess(es) 18A and 18B but having a depth that is equal to the thickness T of the interstitial layer 12C can be formed or cut (e.g., milled or etched) into the respective face 12C' or 12C" of the interstitial layer 12C. Thereafter, material from the opposing brazing layer 30 can be removed (e.g., milling or etching) to form the brazing layer elongated slots 18D having substantially the same pattern, path, array or shape and width as the shallow elongated recess(es) 18A and 18B, wherein the elongated slots 18D include the brazing layer support tabs 42, as described above. In such embodiments, the brazing layer support tabs 42 prevent the interstitial layer interior channel wall sections 22C from falling out or away from the remaining structure of the interstitial layer 12C and provide alignment stability to accurately align the interstitial layer interior channel wall sections 12C with the interior channels wall sections 22A and 22B of the first and second outer layers 12A and 12B when the respective layers are stacked for bonded together. Furthermore, as described above, the brazing layer 30 is fabricated of a material with a lower melting temperature than the material from which the core interstitial layer 30 is fabricated. Therefore, when the layers 12A, 12B and 12C are stacked, aligned, compressed and heated the brazing layer support tabs 42 will melt and diffuse into the composite microchannel(s) 18. In various instances, the layers 12A, 12B and 12C are stacked, aligned, compressed and heated using a low pressure such as between 0-60 psi, for example between 0-20 psi.

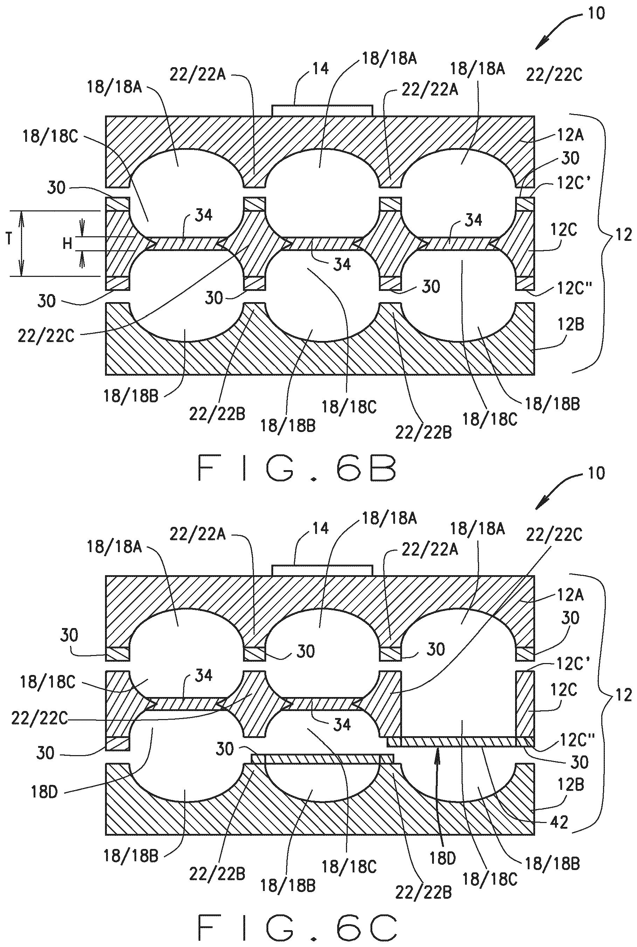

As exemplarily illustrated in Figure 6B, alternatively in the various embodiments wherein both faces 12C' and 12C" of an interstitial layer 12C are clad with the brazing layer 30, the interstitial layer elongated slots 18C can be formed or cut by first removing (e.g., milling or etching) the brazing material of each of the brazing layers 30 to form the brazing layer elongated slots 18D on both faces 12C' and 12C" of the interstitial layer 12C. Thereafter wide shallow elongated recesses having substantially the same pattern, path, array or shape and width as the shallow elongated recess(es) 18A and 18B can be formed or cut (e.g., milled or etched) into each of the faces 12C' or 12C" of the interstitial layer 12C such that the opposing elongated recesses intersect, interconnect and fluidly connect to form the elongated slot(s) 18C as described above. However, in such embodiments, the elongated slots 18C are formed, created or disposed through the interstitial layer(s) 12C to have a plurality of the support tabs 34, as described above. In such embodiments, the interstitial layer support tabs 34 prevent the interstitial layer interior channel wall sections 22C from falling out or away from the remaining structure of the interstitial layer 12C and provide alignment stability to accurately align the interstitial layer interior channel wall sections 12C with the interior channels wall sections 22A and 22B of the first and second outer layers 12A and 12B when the respective layers are stacked for bonded together.

As exemplarily illustrated in Figure 6C, in various embodiments, one or both of the outer layers 12A or 12B can be clad on one face with a layer 30 brazing material. For example, as exemplarily illustrated in the left composite microchannel 18 shown in Figure 6C, in the embodiments wherein one of the outer layers 12A or 12B is clad on one face with a layer 30 of brazing material and one of the faces 12C' or 12C" of the interstitial layer 12C is clad with a layer 30 of brazing material, the interstitial layer elongated slots 18C can be formed by first removing (e.g., milling or etching) the brazing material of the brazing layer 30 disposed on the interstitial layer 12C to form the brazing layer elongated slots 18D. Thereafter, the interconnecting wide shallow elongated recesses in both interstitial layer faces 12C' and 12C" can be formed or cut (e.g., milled or etched) as described above with regard to Figures 6B. Additionally, the interstitial layer support tabs 34 would be formed within the resulting interstitial layer elongated slots 18C, as also described above with regard to Figure 6B.

Alternatively, as exemplarily illustrated in the right composite microchannel 18 shown in Figure 6C, in the embodiments wherein one of the outer layers 12A or 12B is clad on one face with a layer 30 of brazing material and one of the faces 12C' or 12C" of the interstitial layer 12C is clad with a layer 30 of brazing material, the interstitial layer elongated slots 18C can be formed by forming or cutting (e.g., milling or etching) the wide deep interstitial layer elongated slots 18C into the non-brazing clad face 12C' or 12C", wherein the interstitial layer elongated slots 18C have a depth that is equal to the thickness T of the interstitial layer 12C as described above with regard to Figure 6A. Additionally, the brazing layer elongated slots 18D with support tabs 42 would be formed within the brazing layer 30 of the brazing clad face 12C' or 12C", as also described above with regard to Figure 6A.

Alternatively, as exemplarily illustrated in the middle composite microchannel 18 in the embodiments wherein both of the outer layers 12A or 12B are clad on one face with a layer 30 of brazing material and the interstitial layer 12C is not clad on either face 12C' or 12C" with a layer 30 of brazing material the interstitial layer elongated slots 18C can be formed by forming or cutting (e.g., milling or etching) the interconnecting wide shallow elongated recesses in both interstitial layer faces 12C' and 12C" as described above with regard to Figures 6B. Additionally, the interstitial layer support tabs 34 would be formed within the resulting interstitial layer elongated slots 18C, as also described above with regard to Figure 6B.

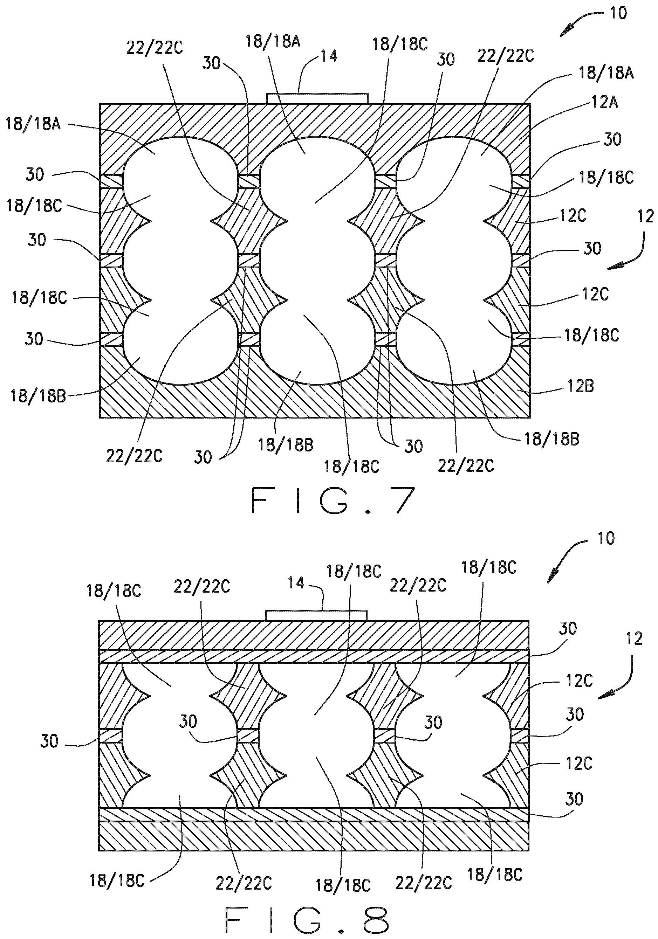

Referring now to Figure 7, as described above, the multilayer microchannel heat transfer body 12 can comprise one or more interstitial layer, plate, stratum or substrate 12C disposed between and bonded to the first and second outer layers 12A and 12B. For example, as shown in Figure 7 in various embodiments, the multilayer microchannel heat transfer body 12 can comprise the first outer layer, plate stratum or substrate 12A, the second outer layer, plate, stratum or substrate 12B, and a plurality of interstitial layers, plates, stratums or substrates 12C disposed between and bonded to the first and second outer layers 12A and 12B.

In various instances of such embodiments, the braze material layers 30 can be independent from the first outer layer 12A, the second outer layer 12B, and the plurality of interstitial layers 12C, as described above with regard to Figure 5. Additionally, the composite microchannel(s) 18 (e.g., the first and second outer layer elongated recesses 18A and 18B, the interstitial layer elongated slots 18C, the brazing layer elongated slots 18D, the interstitial layer support tabs 34 and the brazing layer support tabs 42) can be formed as described above with regard to Figures 3A, 3B, 4A, 4B, 4C and 5. Furthermore, the body 12 with the hermetically sealed composite microchannel(s) 18 can be formed by stacking, aligning, compressing and heating the first and second outer layers 12A and 12B, the plurality of interstitial layers 12C and the brazing layers 30 as described above with regard to Figures 1 through 6C.

In various other instances of such embodiments, the first outer layer 12A, and/or the second outer layer 12B, and/or one or more of the interstitial layers 30 can be fabricated to include (i.e., be clad with) the brazing layer 30 disposed on one or more face thereof, as described above with regard to Figures 6A, 6B and 6C. Additionally, the composite microchannel(s) 18 (e.g., the first and second outer layer elongated recesses 18A and 18B, the interstitial layer elongated slots 18C, the brazing layer elongated slots 18D, the interstitial layer support tabs 34 and/or the brazing layer support tabs 42) can be formed as described above with regard to Figures 4A, 4B, 4C, 6A, 6B and 6C. Furthermore, the body 12 with the hermetically sealed composite microchannel(s) 18 can be formed by stacking, aligning, compressing and heating the first and second outer layers 12A and 12B, the plurality of interstitial layers 12C and the brazing layers 30 as described above with regard to Figures 1 through 6C.

Referring now to Figure 8, it is envisioned that in various embodiments the multilayer microchannel body 12 of the multilayer microchannel heat transfer device 10 can comprise a plurality of interstitial layer 12C comprising the elongated slots 18C, wherein the interstitial layer(s) 12C is/are disposed between a first outer layer 112A and a second outer layer 112B, wherein the first and second outer cover layers 112A and 112B are absent the elongated recesses 18A and 18B. Accordingly, in such embodiments the composite microchannel(s) 18 are formed by the aligning and stacking of the interstitial layer elongated slots 18C. Additionally, the brazing layers 30 can be independent or disposed on one or more of the first and second outer cover layers 112A and 112B and the interstitial layers 12C. Furthermore, the interstitial layer elongated slots 18C, the brazing layer elongated slots 18D, the interstitial layer support tabs 34 and/or the brazing layer support tabs 42) can be formed as described above with regard to Figures 3A through 6C. Still further, the body 12 with the hermetically sealed composite microchannel(s) 18 can be formed by stacking, aligning, compressing and heating the plurality of interstitial layers 12C and the brazing layers 30 as described above with regard to Figures 1 through 6C.

Although the various embodiments of the multilayer microchannel heat transfer device 10 have been exemplarily described to be fabricated utilizing either independent brazing layers 30 or cladding brazing layers 30 (i.e., one or more of the first and second outer layers 12A and 12B and/or the interstitial layer(s) 12C are fabricated to have the brazing layer(s) 30 disposed thereon as cladding) these exemplary embodiments are not limiting. Particularly, it is envisioned that any of the various exemplary embodiments of the described herein can be fabricated utilizing the combination of one or more independent brazing layer 30 and one or more cladding brazing layer 30.

It should also be noted that the various layers of each of the various exemplary embodiments of the multilayer microchannel heat transfer device 10 described herein can be made from a wide range of material and in generally any shape and size desired in order to meet the specifications of a given application's heat source(s) and heat sink(s) or rejection regions(s) (e.g. the respective sizes, heat loads, heat fluxes, locations, temperatures, gravitational fields, coefficients of thermal expansion requirements, etc., of the device 10). Additionally, the pattern, path, array or shape of composite microchannel(s) 18 can form a closed-loop (e.g., circulating), or can be sealed at each end to form an openloop (e.g. serpentine or linear). Furthermore, the pattern, path, array or shape of composite microchannel(s) 18 can travel in two dimensions (i.e., in x-y plane or in a r-θ plane) or in all three physical dimensions (i.e., x-y-z and/or r-θ-h). Still further, the cross-sectional geometry of the composite microchannel(s) 18 can have generally any desired shapes and composite microchannel lengths can vary (e.g., from less than 1 cm to greater than 10 m) so long as the composite microchannel(s) 18 maintain the capillary effect where the working fluid inside the channel volume is dispersed in discrete liquid "plugs" and vapor "bubbles". Still yet further, the working fluid can be any desired working fluid selected based on its thermophysical properties (e.g., vapor pressures, latent heats, specific heats, densities, surface tensions, critical temperatures, pour points, viscosities, etc.) and compatible with the material(s) used to form the body and channels.

The description herein is merely exemplary in nature and, thus, variations that do not depart from the gist of that which is described are intended to be within the scope of the invention as defined in the appended claims.

## Claims

1. A multilayer microchannel heat transfer device, said device comprising:
a multilayer body, wherein the multilayer body comprises:
a first outer layer comprising at least one micro-sized first elongated recess formed therein;
a second outer layer comprising at least one micro-sized second elongated recess formed therein, and
at least one interstitial layer comprising at least one micro-sized elongated interstitial slot formed therethrough,
wherein the first outer layer, the second outer layer, and the at least one interstitial layer are stacked and bonded together having the at least one interstitial layer disposed between the first and second outer layer, whereby the at least one first elongated recess in the first outer layer, the at least one second elongated recess in the second outer layer and the at least one elongated slot in the at least one interstitial layer are aligned and combine to form at least one deep narrow composite microchannel having a high height to width aspect ratio internally disposed and enclosed within the resulting multilayer body,
**characterized in that** the at least one interstitial layer elongated slot comprises a plurality of interstitial layer support tabs that extend across the at least one interstitial elongated slot.

2. The device of Claim 1, wherein the body further comprises a plurality of brazing layers, each brazing layer comprising at least one elongated slot, wherein each brazing layer is one of:
disposed between the first outer layer and an adjacent one of the at least one interstitial layer;
disposed between the second outer layer and an adjacent one of the at least one interstitial layer; and
when the at least one interstitial layer comprises a plurality of interstitial layers, disposed between adjacent interstitial layers.

3. The device of any of Claims 1 or 2, wherein, prior to the first outer layer, the second outer layer, and the at least one interstitial layer being stacked and bonded together, the brazing layers are separate and independent from the to the first outer layer, the second outer layer, and the at least one interstitial layer.

4. The device of any of claims 1 to 3, wherein the at least one brazing layer elongated slot comprises a plurality of brazing layer support tabs that extend across the at least one brazing layer elongated slot.

5. The device of any of claims 1 to 4, wherein the at least one interstitial layer elongated slot comprises opposing intersecting and fluidly connected micro-sized elongated recesses.

6. The device of Claim 2, wherein, prior to the first outer layer, the second outer layer, and the at least one interstitial layer being stacked and bonded together, at least one face of at least one of the first outer layer, the second outer layer, and the at least one interstitial layer comprises one of the brazing layers disposed thereon such that the respective face is clad with the respective brazing layer.

7. The device of Claim 6, wherein the at least one of:
at least one interstitial layer elongated slot comprises a plurality of interstitial layer support tabs that extend across the at least one interstitial elongated slot; and
at least one brazing layer elongated slot comprises a plurality of brazing layer support tabs that extend across the at least one brazing layer elongated slot.

8. A method of fabricating a multilayer microchannel heat transfer device, said method comprising:
forming at least one micro-sized first elongated recess within a first substrate to fabricate a first outer layer;
forming at least one micro-sized second elongated recess within a second substrate to fabricate a second outer layer;
forming at least one micro-sized elongated interstitial slot within at least one interstitial substrate to fabricate at least one interstitial layer; and
disposing the at least one interstitial layer between the first outer layer and the second outer layer to form a multilayer body, wherein the first outer layer, the second outer layer, and the at least one interstitial layer are stacked and bonded together such that the at least one first elongated recess in the first outer layer, the at least one second elongated recess in the second outer layer and the at least one elongated slot in the at least one interstitial layer are aligned and combine to form at least one deep narrow composite microchannel having a high height to width aspect ratio internally disposed and enclosed within the multilayer body, **characterized in that** the method further comprises:
forming a plurality of interstitial layer support tabs that extend across the at least one interstitial elongated slot.

9. The method of Claim 8, wherein the method further comprises:
providing a plurality of brazing layers, each brazing layer comprising at least one elongated slot; and one of:
disposing one of the plurality of brazing layers between the first outer layer and an adjacent one of the at least one interstitial layer;
disposing one of the plurality of brazing layers between the second outer layer and an adjacent one of the at least one interstitial layer; and
when the at least one interstitial layer comprises a plurality of interstitial layers, disposing one of the plurality of brazing layers between adjacent interstitial layers.

10. The method of any of claims 8 or 9 wherein, prior to the first outer layer, the second outer layer, and the at least one interstitial layer being stacked and bonded together, the brazing layers are separate and independent from the to the first outer layer, the second outer layer, and the at least one interstitial layer.

11. The method of any of claims 8 to 10, wherein providing the plurality of brazing layers comprises forming the at least one brazing layer elongated slot to comprises a plurality of brazing layer support tabs that extend across the at least one brazing layer elongated slot.

12. The method of any of claims 8 to 11, wherein forming at least one elongated interstitial slot within at least one interstitial substrate to fabricate at least one interstitial layer comprises:
forming at least one first micro-sized elongated recess within a first face of the at least one interstitial layer; and
forming at least one opposing second micro-sized elongated recess within a second face of the at least one interstitial layer such that first and second micro-sized elongated recesses intersect and fluidly connect to form the at least one elongated interstitial slot.

13. The method of Claim 9, wherein, prior to the first outer layer, the second outer layer, and the at least one interstitial layer being stacked and bonded together, at least one face of at least one of the first outer layer, the second outer layer, and the at least one interstitial layer comprises one of the brazing layers disposed thereon such that the respective face is clad with the respective brazing layer.

## Patentansprüche

1. Eine mehrlagige Mikrokanal-Wärmeübertragungsvorrichtung, wobei die Vorrichtung aufweist:
einen mehrlagigen Körper, wobei der mehrlagige Körper aufweist:
eine erste Außenschicht, die mindestens eine mikrogroße erste längliche Vertiefung darin ausgebildet aufweist;
eine zweite Außenschicht, die mindestens eine mikrogroße zweite längliche Vertiefung darin ausgebildet aufweist, und
mindestens eine Zwischenschicht, die mindestens einen mikrogroßen länglichen Zwischenschlitz hindurch ausgebildet aufweist,
wobei die erste Außenschicht, die zweite Außenschicht und die mindestens eine Zwischenschicht gestapelt und stoffschlüssig verbunden sind, wobei die mindestens eine Zwischenschicht zwischen der ersten und der zweiten Außenschicht angeordnet ist, wodurch die mindestens eine erste längliche Vertiefung in der ersten Außenschicht, die mindestens eine zweite längliche Vertiefung in der zweiten Außenschicht und der mindestens eine längliche Schlitz in der mindestens einen Zwischenschicht ausgerichtet sind und sich zu mindestens einem tiefen schmalen zusammengesetzten Mikrokanal mit einem hohen Höhen-zu-Breiten-Seitenverhältnis verbinden, der intern angeordnet und innerhalb des resultierenden mehrlagigen Körpers eingeschlossen ist,
**dadurch gekennzeichnet, dass** der mindestens eine längliche Zwischenschlitz der mindestens einen Zwischenschicht eine Vielzahl von Zwischenschicht-Stützstegen aufweist, die sich über den mindestens einen länglichen Zwischenschlitz erstrecken.

2. Die Vorrichtung nach Anspruch 1, wobei der Körper ferner eine Vielzahl von Lötzwischenschichten aufweist, wobei jede Lötzwischenschicht mindestens einen länglichen Schlitz aufweist, wobei jede Lötzwischenschicht ausgewählt ist aus:
zwischen der ersten Außenschicht und einer benachbarten der mindestens einen Zwischenschicht angeordnet;
zwischen der zweiten Außenschicht und einer benachbarten der mindestens einen Zwischenschicht angeordnet; und
wenn die mindestens eine Zwischenschicht eine Vielzahl von Zwischenschichten aufweist, zwischen benachbarten Zwischenschichten angeordnet.

3. Die Vorrichtung nach einem der Ansprüche 1 oder 2, wobei, bevor die erste Außenschicht, die zweite Außenschicht und die mindestens eine Zwischenschicht gestapelt und stoffschlüssig verbunden sind, die Lötzwischenschichten getrennt und unabhängig von der ersten Außenschicht, der zweiten Außenschicht und der mindestens einen Zwischenschicht sind.

4. Die Vorrichtung nach einem der Ansprüche 1 bis 3, wobei der mindestens eine längliche Schlitz der Lötzwischenschicht eine Vielzahl von Lötzwischenschicht-Stützstegen aufweist, die sich über den mindestens einen länglichen Schlitz der Lötzwischenschicht erstrecken.

5. Die Vorrichtung nach einem der Ansprüche 1 bis 4, wobei der mindestens eine längliche Zwischenschlitz der mindestens einen Zwischenschicht gegenüberliegende sich kreuzende und fluidisch miteinander verbundene mikrogroße längliche Vertiefungen aufweist.

6. Die Vorrichtung nach Anspruch 2, wobei, bevor die erste Außenschicht, die zweite Außenschicht und die mindestens eine Zwischenschicht gestapelt und stoffschlüssig verbunden sind, mindestens eine Fläche von mindestens einer der ersten Außenschicht, der zweiten Außenschicht und der mindestens einen Zwischenschicht eine der Lötzwischenschichten aufweist, die darauf angeordnet ist, sodass die jeweilige Fläche mit der jeweiligen Lötzwischenschicht plattiert ist.

7. Die Vorrichtung nach Anspruch 6, wobei mindestens eines von Folgendem gilt:
der mindestens eine längliche Zwischenschlitz der mindestens einen Zwischenschicht weist eine Vielzahl von Zwischenschicht-Stützstegen auf, die sich über den mindestens einen länglichen Zwischenschlitz der Zwischenschicht erstrecken; und
der mindestens eine längliche Schlitz der Lötzwischenschicht weist eine Vielzahl von Lötzwischenschicht-Stützstegen auf, die sich über den mindestens einen länglichen Schlitz der Lötzwischenschicht erstrecken.

8. Ein Verfahren zur Herstellung einer mehrlagigen Mikrokanal-Wärmeübertragungsvorrichtung, wobei das Verfahren aufweist:
Ausbilden von mindestens einer mikrogroßen ersten länglichen Vertiefung innerhalb eines ersten Substrats, um eine erste Außenschicht herzustellen;
Ausbilden von mindestens einer mikrogroßen zweiten länglichen Vertiefung innerhalb eines zweiten Substrats, um eine zweite Außenschicht herzustellen;
Ausbilden von mindestens einem mikrogroßen länglichen Zwischenschlitz innerhalb von mindestens einem Zwischensubstrat, um mindestens eine Zwischenschicht herzustellen; und
Anordnen der mindestens einen Zwischenschicht zwischen der ersten Außenschicht und der zweiten Außenschicht, um einen mehrlagigen Körper zu bilden, wobei die erste Außenschicht, die zweite Außenschicht und die mindestens eine Zwischenschicht gestapelt und stoffschlüssig verbunden sind, sodass die mindestens eine erste längliche Vertiefung in der ersten Außenschicht, die mindestens eine zweite längliche Vertiefung in der zweiten Außenschicht und der mindestens eine längliche Schlitz in der mindestens einen Zwischenschicht ausgerichtet sind und sich zu mindestens einem tiefen schmalen zusammengesetzten Mikrokanal mit einem hohen Höhen-zu-Breiten-Seitenverhältnis verbinden, der intern angeordnet und innerhalb des mehrlagigen Körpers eingeschlossen ist,
**dadurch gekennzeichnet, dass** das Verfahren ferner aufweist:
Ausbilden einer Vielzahl von Zwischenschicht-Stützstegen, die sich über den mindestens einen länglichen Zwischenschlitz der Zwischenschicht erstrecken.

9. Das Verfahren nach Anspruch 8, wobei das Verfahren ferner aufweist: Bereitstellen einer Vielzahl von Lötzwischenschichten, wobei jede Lötzwischenschicht mindestens einen länglichen Schlitz aufweist; und eines von:
Anordnen einer der Vielzahl von Lötzwischenschichten zwischen der ersten Außenschicht und einer benachbarten der mindestens einen Zwischenschicht;
Anordnen einer der Vielzahl von Lötzwischenschichten zwischen der zweiten Außenschicht und einer benachbarten der mindestens einen Zwischenschicht; und
wenn die mindestens eine Zwischenschicht eine Vielzahl von Zwischenschichten aufweist, Anordnen einer der Vielzahl von Lötzwischenschichten zwischen benachbarten Zwischenschichten.

10. Das Verfahren nach einem der Ansprüche 8 oder 9, wobei, bevor die erste Außenschicht, die zweite Außenschicht und die mindestens eine Zwischenschicht gestapelt und stoffschlüssig verbunden sind, die Lötzwischenschichten getrennt und unabhängig von der ersten Außenschicht, der zweiten Außenschicht und der mindestens einen Zwischenschicht sind.

11. Das Verfahren nach einem der Ansprüche 8 bis 10, wobei das Bereitstellen der Vielzahl von Lötzwischenschichten das Ausbilden des mindestens einen länglichen Schlitzes der Lötzwischenschicht umfasst, sodass der mindestens eine längliche Schlitz der Lötzwischenschicht eine Vielzahl von Lötzwischenschicht-Stützstegen aufweist, die sich über den mindestens einen länglichen Schlitz der Lötzwischenschicht erstrecken.

12. Das Verfahren nach einem der Ansprüche 8 bis 11, wobei das Ausbilden von mindestens einem länglichen Zwischenschlitz innerhalb von mindestens einem Zwischensubstrat, um mindestens eine Zwischenschicht herzustellen, umfasst:
Ausbilden von mindestens einer ersten mikrogroßen länglichen Vertiefung innerhalb einer ersten Fläche der mindestens einen Zwischenschicht; und
Ausbilden von mindestens einer gegenüberliegenden zweiten mikrogroßen länglichen Vertiefung innerhalb einer zweiten Fläche der mindestens einen Zwischenschicht, sodass sich die erste und die zweite mikrogroße längliche Vertiefung kreuzen und fluidisch miteinander verbinden, um den mindestens einen länglichen Zwischenschlitz zu bilden.

13. Das Verfahren nach Anspruch 9, wobei, bevor die erste Außenschicht, die zweite Außenschicht und die mindestens eine Zwischenschicht gestapelt und stoffschlüssig verbunden sind, mindestens eine Fläche von mindestens einer der ersten Außenschicht, der zweiten Außenschicht und der mindestens einen Zwischenschicht eine der Lötzwischenschichten darauf angeordnet aufweist, sodass die jeweilige Fläche mit der jeweiligen Lötzwischenschicht plattiert ist.

## Revendications

1. Dispositif de transfert de chaleur à microcanaux multicouche, ledit dispositif comprenant :
un corps multicouche, le corps multicouche comprenant :
une première couche externe comprenant au moins un premier évidement allongé de taille micrométrique formé dans celle-ci ;
une seconde couche externe comprenant au moins un second évidement allongé de taille micrométrique formé dans celle-ci ; et
au moins une couche interstitielle comprenant au moins une fente interstitielle allongée de taille micrométrique formée au travers de celle-ci,
la première couche externe, la seconde couche externe et la au moins une couche interstitielle étant empilées et liées entre elles, la au moins une couche interstitielle étant disposée entre la première et la seconde couche externe, de sorte que le au moins un premier évidement allongé dans la première couche externe, le au moins un second évidement allongé dans la seconde couche externe et la au moins une fente allongée dans la au moins une couche interstitielle sont alignés et se combinent pour former au moins un microcanal composite profond et étroit présentant un rapport hauteur/largeur élevé, disposé à l'intérieur et fermé au sein du corps multicouche résultant,
**caractérisé en ce que** la au moins une fente interstitielle allongée de couche interstitielle comprend une pluralité de languettes de support de couche interstitielle qui s'étendent en travers de la au moins une fente interstitielle allongée.

2. Dispositif selon la revendication 1, dans lequel le corps comprend en outre une pluralité de couches de brasage, chaque couche de brasage comprenant au moins une fente allongée de couche de brasage, chaque couche de brasage étant :
soit disposée entre la première couche externe et une couche interstitielle adjacente parmi la au moins une couche interstitielle ;
soit disposée entre la seconde couche externe et une couche interstitielle adjacente parmi la au moins une couche interstitielle ; et
lorsque la au moins une couche interstitielle comprend une pluralité de couches interstitielles, disposée entre des couches interstitielles adjacentes.

3. Dispositif selon l'une quelconque des revendications 1 ou 2, dans lequel, avant que la première couche externe, la seconde couche externe et la au moins une couche interstitielle soient empilées et liées entre elles, les couches de brasage sont séparées et indépendantes de la première couche externe, de la seconde couche externe et de la au moins une couche interstitielle.

4. Dispositif selon l'une quelconque des revendications 1 à 3, dans lequel la au moins une fente allongée de couche de brasage comprend une pluralité de languettes de support de couche de brasage qui s'étendent en travers de la au moins une fente allongée de couche de brasage.

5. Dispositif selon l'une quelconque des revendications 1 à 4, dans lequel la au moins une fente interstitielle allongée de couche interstitielle comprend des évidements allongés de taille micrométrique opposés, se croisant et reliés en termes d'écoulement de fluide.

6. Dispositif selon la revendication 2, dans lequel, avant que la première couche externe, la seconde couche externe et la au moins une couche interstitielle soient empilées et liées entre elles, au moins une face d'au moins l'une parmi la première couche externe, la seconde couche externe et la au moins une couche interstitielle comprend l'une des couches de brasage disposée sur celle-ci de telle sorte que ladite face correspondante soit plaquée par la couche de brasage correspondante.

7. Dispositif selon la revendication 6, dans lequel au moins l'un des éléments suivants est vérifié :
au moins une fente interstitielle allongée de couche interstitielle comprend une pluralité de languettes de support de couche interstitielle qui s'étendent en travers de la au moins une fente interstitielle allongée ; et
au moins une fente allongée de couche de brasage comprend une pluralité de languettes de support de couche de brasage qui s'étendent en travers de la au moins une fente allongée de couche de brasage.

8. Procédé de fabrication d'un dispositif de transfert de chaleur à microcanaux multicouche, ledit procédé comprenant :
former au moins un premier évidement allongé de taille micrométrique dans un premier substrat pour fabriquer une première couche externe ;
former au moins un second évidement allongé de taille micrométrique dans un second substrat pour fabriquer une seconde couche externe ;
former au moins une fente interstitielle allongée de taille micrométrique dans au moins un substrat interstitiel pour fabriquer au moins une couche interstitielle ; et
disposer la au moins une couche interstitielle entre la première couche externe et la seconde couche externe pour former un corps multicouche, la première couche externe, la seconde couche externe et la au moins une couche interstitielle étant empilées et liées entre elles de telle sorte que le au moins un premier évidement allongé dans la première couche externe, le au moins un second évidement allongé dans la seconde couche externe et la au moins une fente allongée dans la au moins une couche interstitielle soient alignés et se combinent pour former au moins un microcanal composite profond et étroit présentant un rapport hauteur/largeur élevé, disposé à l'intérieur et fermé au sein du corps multicouche,
**caractérisé en ce que** le procédé comprend en outre :
former une pluralité de languettes de support de couche interstitielle qui s'étendent en travers de la au moins une fente interstitielle allongée.

9. Procédé selon la revendication 8, dans lequel le procédé comprend en outre :
fournir une pluralité de couches de brasage, chaque couche de brasage comprenant au moins une fente allongée ; et l'une des étapes suivantes :
disposer l'une de la pluralité de couches de brasage entre la première couche externe et une couche interstitielle adjacente parmi la au moins une couche interstitielle ;
disposer l'une de la pluralité de couches de brasage entre la seconde couche externe et une couche interstitielle adjacente parmi la au moins une couche interstitielle ; et
lorsque la au moins une couche interstitielle comprend une pluralité de couches interstitielles, disposer l'une de la pluralité de couches de brasage entre des couches interstitielles adjacentes.

10. Procédé selon l'une quelconque des revendications 8 ou 9, dans lequel, avant que la première couche externe, la seconde couche externe et la au moins une couche interstitielle soient empilées et liées entre elles, les couches de brasage sont séparées et indépendantes de la première couche externe, de la seconde couche externe et de la au moins une couche interstitielle.

11. Procédé selon l'une quelconque des revendications 8 à 10, dans lequel la fourniture de la pluralité de couches de brasage comprend la formation d'au moins une fente allongée de couche de brasage de manière à comprendre une pluralité de languettes de support de couche de brasage qui s'étendent en travers de la au moins une fente allongée de couche de brasage.

12. Procédé selon l'une quelconque des revendications 8 à 11, dans lequel la formation d'au moins une fente interstitielle allongée dans au moins un substrat interstitiel pour fabriquer au moins une couche interstitielle comprend :
former au moins un premier évidement allongé de taille micrométrique dans une première face de la au moins une couche interstitielle ; et
former au moins un second évidement allongé de taille micrométrique opposé dans une seconde face de la au moins une couche interstitielle, de telle sorte que les premier et second évidements allongés de taille micrométrique se croisent et soient reliés en termes d'écoulement de fluide pour former la au moins une fente interstitielle allongée.

13. Procédé selon la revendication 9, dans lequel, avant que la première couche externe, la seconde couche externe et la au moins une couche interstitielle soient empilées et liées entre elles, au moins une face d'au moins l'une parmi la première couche externe, la seconde couche externe et la au moins une couche interstitielle comprend l'une des couches de brasage disposée sur celle-ci de telle sorte que ladite face correspondante soit plaquée par la couche de brasage correspondante.
